# FASCICULE DE BREVET EUROPEEN

(11) **EP 0 434 144 B1**
(45) Date de publication et mention de la délivrance du brevet: **15.03.1995**
(21) Numéro de dépôt: 90203316.6
(22) Date de dépôt: 13.12.1990
(51) Int. Cl.: H01P 5/10, H03H 7/38

(54) **Symétriseur**
Symmetriereinrichtung
Balun

(30) Priorité: 19.12.1989 FR 8916803
(43) Date de publication de la demande: 26.06.1991
(73) Titulaire: PHILIPS ELECTRONIQUE GRAND PUBLIC, 92156 Suresnes Cédex (FR); Philips Electronics N.V., 5621 BA Eindhoven (NL)
(72) Inventeur: Chanteau, Pierre, F-75008 Paris (FR)
(74) Mandataire: Charpail, François

(56) Documents cités:
- DE-A- 1 944 847
- GB-A- 918 667
- GB-A- 1 172 254
- GB-A- 2 084 809
- US-A- 4 160 210
- H.JASIK: "ANTENNA ENGINEERING HANDBOOK" 1961, McGRAW-HILL, New York

## Description

La présente invention a pour objet un symétriseur et adaptateur d'impédance, constitué de deux enroulements bifilaires pour connecter entre eux un câble coaxial dissymétrique et une antenne symétrique, cependant que pour un premier enroulement bifilaire un premier fil est connecté entre la masse et à nouveau la masse, et le second fil est connecté entre un brin de l'antenne et l'âme du câble, alors que pour le second enroulement bifilaire un premier fil est connecté entre l'âme du câble et la masse, et le second fil est connecté entre l'autre brin de l'antenne et la masse, symétriseur comportant une plaquette support pour y fixer lesdits éléments, ladite plaquette support étant un circuit imprimé monoface, lesdits deux enroulements bifilaires étant entièrement gravés à plat sur le circuit imprimé.

Un tel symétriseur est utilisé pour la réception de signaux haute fréquence, comme ceux de la télévision, et il est situé entre une antenne dipôle dont l'impédance est généralement de 400 Ω et un câble coaxial dont l'impédance est généralement de 75 Ω ; de par cet usage on pourrait aussi lui donner le nom de "asymétriseur". Un autre type d'antenne symétrique est l'antenne trombone.

Le principe d'un symétriseur à deux enroulements bifilaires est connu depuis longtemps, par exemple comme indiqué dans "Antenna Engineering Handbook" de Henry JASIK publié en 1961, à la page 31-23 sous la dénomination : "Type 6, bifilar-coil or elevator balun".

A ce jour, on constate que bien des symétriseurs commercialisés sont fabriqués selon le principe du "type 5, half-wave-line balun" (même référence), c'est-à-dire selon le principe du symétriseur comportant une ligne demi-onde. Toutefois, un symétriseur de ce type ne peut avoir un fonctionnement satisfaisant en large bande, par exemple pour la bande UHF qui couvre une octave, du fait qu'il n'est bien adapté que pour la longueur d'onde choisie lors de l'implémentation de la ligne.

Une réalisation d'un symétriseur de type 6, selon le préambule ci-dessus, est connue de DE-GM- 1 944 847. Elle présente une bonne qualité d'adaptation pour toute la bande UHF, mais a l'inconvénient de nécessiter une connexion rapportée au moyen d'un fil soudé en reprise.

La présente invention a pour but la réalisation d'un symétriseur de faible coût ayant au moins les mêmes performances que les meilleurs symétriseurs existants.

En effet, une des difficultés à implémenter un symétriseur de type connu sur un circuit imprimé est due au fait que certaines connexions doivent se croiser, ce qui n'est pas possible en monoface sauf en ajoutant des fils soudés (jumpers).

Le document GB-A- 9 18 667 décrit un symétriseur dans lequel le problème du croisement est résolu par un conducteur placé sur la face arrière du circuit imprimé. Ce conducteur sert également de connecteur. La solution proposée selon la présente invention est particulièrement simple et peu coûteuse.

Selon l'invention un symétriseur tel que défini dans le préambule est particulièrement remarquable en ce que l'âme du câble coaxial est fixée amovible sur un embout conducteur comportant deux pattes pour être fixé par soudure sur ledit circuit imprimé, lequel comporte deux évidements pour y loger lesdites pattes, dont l'une est reliée au second fil du premier enroulement, et l'autre est reliée au premier fil du second enroulement, la connexion à la masse du second fil du second enroulement étant réalisée en passant entre lesdits deux évidements de telle sorte que ledit embout conducteur, soudé sur le circuit imprimé pour la fixation de l'âme du câble coaxial, fait aussi office de cavalier de connexion pour connecter entre elles les deux dites lignes connectées auxdits évidements et situées de part et d'autre de la masse.

Avantageusement chaque brin est situé à environ 50 mm l'un de l'autre, il est ainsi possible de réaliser un symétriseur ayant de bonnes performances dont les dimensions extérieures sont de l'ordre de 60 x 35 mm.

La présente invention sera bien comprise avec un exemple non limitatif de réalisation illustré par des figures.

La figure 1 représente une vue cavalière globale d'un symétriseur connecté.

La figure 2 représente la face soudée du circuit imprimé, laquelle face n'est pas visible sur la figure 1.

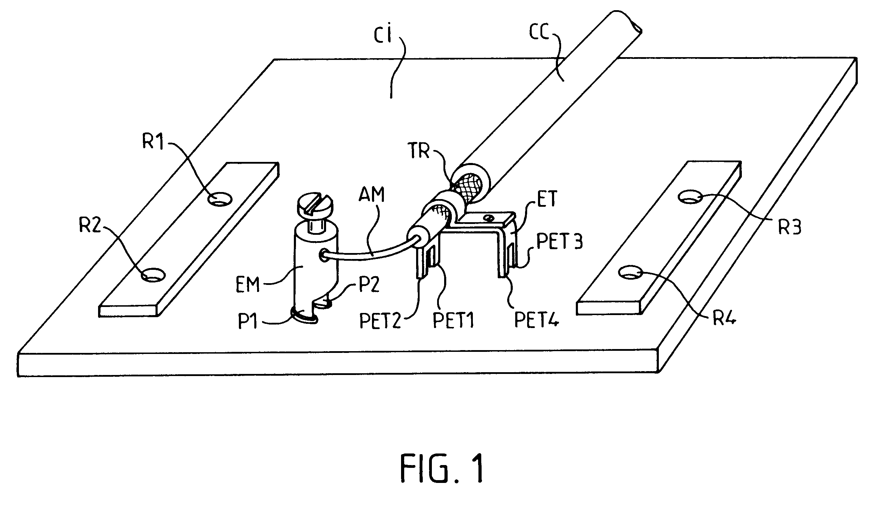

La figure 1 représente un symétriseur conforme à l'invention. La plaque support est un circuit imprimé (CI) dont la face soudée est invisible les brins d'une antenne sont fixés sur la plaque (CI) par des moyens de fixation non représentés, par exemple des rivets, traversant la plaque en R1, R2, R3, R4 ; le câble coaxial (CC) est fixé et connecté par un étrier (ET) pour la tresse de masse (TR) et par un embout (EM) pour l'âme (AM) ; l'étrier (ET) comporte des pattes (PET1, PET2, PET3, PET4) qui traversent la plaque (CI) pour accéder à la face soudée ; de même l'embout (EM) comporte deux pattes (P1, P2) pour accéder à la face soudée.

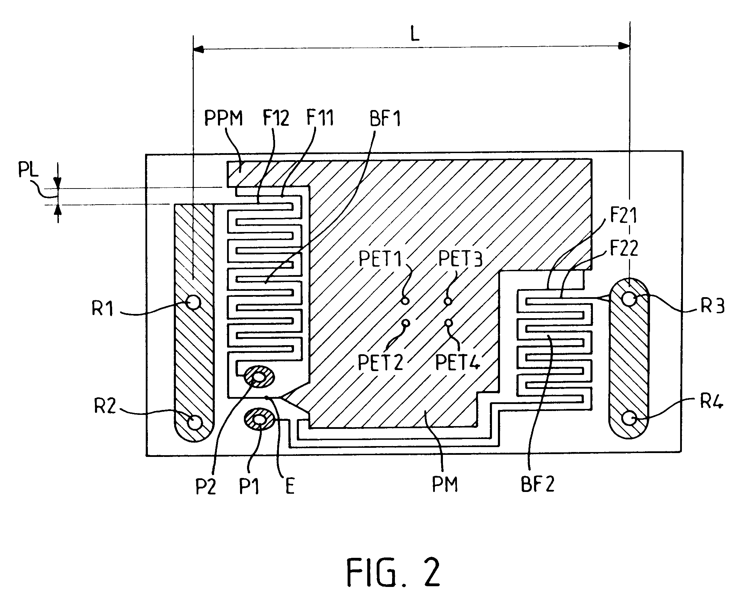

La figure 2 représente la face soudée et/ou imprimée du circuit imprimé et/ou plaque support.

On y retrouve évidemment les éléments de fixation et de connexion par soudure déjà décrits à savoir :
- R1, R2, R3, R4 pour l'antenne,
- PET1, PET2, PET3, PET4 pour l'étrier connecté à la masse,
- P1, P2 pour l'embout connecté à l'âme du câble coaxial.

Les deux enroulements bifilaires (BF1, BF2) sont entièrement gravés à plat sur le circuit imprimé ; la gravure de chaque fil (F11, F12 et F21, F22) suit des méandres pour obtenir la longueur nécessaire et suffisante ; pour le symétriseur décrit, lequel est adapté à la bande UHF, cette longueur est de l'ordre de 120 mm ; la partie bifilaire est la plus longue possible, c'est-à-dire que la connexion au bout de chaque fil en parcours libre est de longueur pratiquement nulle pour ne présenter ni self ni capacité parasites.

A titre d'exemple, le plan de masse a été prolongé PPM pour que le parcours libre PL de la connexion du fil F11 soit minimum.

Le fil F12 connecte un brin de l'antenne au plan de masse PM.

Le fil F11 connecte la masse PM à la patte P2 de l'embout.

Le fil F21 connecte la masse PM à la masse PM.

Le fil F22 connecte l'autre brin de l'antenne à l'autre patte P1 de l'embout.

Il est clair que si l'embout EM ne faisait pas aussi office de cavalier (ou "jumper"), il serait impossible de connecter l'extrémité E de F12 avec la masse PM, et de connecter P1 avec P2 puisque les deux connexions se croiseraient dans le plan de soudure. L'agencement de l'embout EM de la figure 1 avec ses deux pattes P1 et P2 a donc un rôle très important malgré son apparence anodine.

Le symétriseur ainsi réalisé possède d'excellentes performances pour toute la gamme UHF puisqu'il est bifilaire et non pas demi-onde, de plus il est très économique à réaliser du fait de la sobriété des moyens mis en oeuvre, ce qui implique un coût de main d'oeuvre réduit et même des possibilités d'automatisation de la production.

A titre d'information complémentaire, la figure 2 est pratiquement "à l'échelle" si l'on tient compte de ce que les brins de l'antenne sont situés à une distance L l'un de l'autre de l'ordre de 50 mm ; la dimension extérieure du circuit imprimé est alors sensiblement égale à 60 x 35 mm.

L'exemple décrit est particulièrement convenable pour une antenne dipôle symétrique mais il est clair que le principe de la présente invention convient pour les autres types d'antennes symétriques, notamment l'antenne trombone.

## Revendications

1. Symétriseur et adaptateur d'impédance, constitué de deux enroulements bifilaires pour connecter entre eux un câble coaxial dissymétrique (CC) et une antenne symétrique, cependant que pour un premier enroulement bifilaire un premier fil (F21) est connecté entre la masse et à nouveau la masse et le second fil (F22) est connecté entre un brin de l'antenne et l'âme du câble, alors que pour le second enroulement bifilaire un premier fil (F11) est connecté entre l'âme du câble et la masse, et le second fil (F12) est connecté entre l'autre brin de l'antenne et la masse, symétriseur comportant une plaquette support pour y fixer lesdits éléments, ladite plaquette support étant un circuit imprimé monoface, lesdits deux enroulements bifilaires étant entièrement gravés à plat sur le circuit imprimé, caractérisé en ce que l'âme du câble coaxial est fixée amovible sur un embout conducteur (EM) comportant deux pattes (P1, P2) pour être fixé par soudure sur ledit circuit imprimé, lequel comporte deux évidements pour y loger lesdites pattes, qui sont reliées respectivement, l'une au second fil du premier enroulement, l'autre au premier fil du second enroulement, la connexion à la masse du second fil du second enroulement (F12) étant réalisée en passant entre lesdits deux évidements de telle sorte que ledit embout conducteur (EM), soudé sur le circuit imprimé pour la fixation de l'âme du câble coaxial, fait aussi office de cavalier de connexion pour connecter entre elles les deux dites lignes (F11, F22) connectées auxdits évidements et situées de part et d'autre de la masse.

2. Symétriseur selon la revendication 1, caractérisé en ce que chaque brin de l'antenne est fixé sur le circuit imprimé à une distance (L) d'environ 50 mm l'un de l'autre, et le circuit imprimé a une dimension extérieure d'environ 60 x 35 mm.

## Patentansprüche

1. Symmetrierglied und Adapter für die Impedanz, der aus zwei Doppeldrahtwicklungen zum Verbinden eines asymmetrischen Koaxialkabels (CC) und einer symmetrischen Antenne zwischen ihnen besteht, während für eine erste Doppeldrahtwicklung ein erster Draht (F21) zwischen der Masse und wiederum der Masse angeschlossen und der zweite Draht (F22) zwischen einem Antennendraht und der Kabelseele angeschlossen werden, während für die zweite Doppeldrahtwicklung ein erster Draht (F11) zwischen der Kabelseele und Masse und der zweite Draht (F12) zwischen dem anderen Antennendraht und Masse angeschlossen werden, wobei das Symmetrierglied eine Trägerplatte zum Befestigen der Elemente darauf enthält, diese Trägerplatte eine einflächige Leiterplatte ist, und diese zwei Doppeldrahtwicklungen auf der Leiterplatte ganz flach eingraviert sind, dadurch gekennzeichnet, daß die Koaxialkabelseele abnehmbar auf einem Leiterausläufer (EM) mit zwei Halterungen (P1, P2) zum Befestigen durch Verlöten auf der Leiterplatte befestigt ist, die zwei Ausnehmungen zum Aufnehmen der Halterungen enthält, von denen eine mit dem zweiten Draht der ersten Wicklung und die andere mit dem ersten Draht der zweiten Wicklung verbunden sind, wobei die Masseverbindung des zweiten Drahtes der zweiten Wicklung (F12) durch Verlegen zwischen den zwei Ausnehmungen derart verwirklicht wird, daß der Leiterausläufer (EM), der für die Befestigung der Koaxialkabelseele auf der Leiterplatte verlötet ist, ebenfalls die Aufgabe des Verbindungsreiters zum Verbinden der zwei mit den Ausnehmungen verbundenen Leiter (F11, F12) an beiden Seiten der Masse erfüllt.

2. Symmetrierglied nach Anspruch 1, dadurch gekennzeichnet, daß jeder Antennendraht auf der Leiterplatte in einem Abstand (L) von etwa 50 mm vom anderen befestigt ist, und daß die Außenabmessung der Leiterplatte etwa 60 x 35 mm beträgt.

## Claims

1. A balun and impedance matching element, formed by two bifilar windings for interconnecting an asymmetrical coaxial cable (CC) and a symmetrical antenna, be it that for a first bifilar winding a first wire (F21) is connected between ground and ground again and that the second wire (F22) is connected between a wire of the antenna and the core of the cable, whereas for the second bifilar winding a first wire (F11) is connected between the core of the cable and ground and the second wire (F12) is connected between the other wire of the antenna and ground, which balun comprises a carrier board for the mounting of said elements, said carrier board being a one-sided printed circuit and said two bifilar windings being formed entirely as flat conductors extending on said printed circuit, characterized in that the core of the coaxial cable is rigidly connected to a conductive stud (EM) which comprises two legs (P1, P2) which are to be soldered onto said printed circuit which is provided with two passages for said legs, one of which is connected to the second wire of the first winding whereas the other is connected to the first wire of the second winding, the connection to ground of the second wire (F12) of the second winding being realized while passing between said two passages so that said conductive stud (EM), soldered to the printed circuit so as to secure the core of the coaxial cable, also serves as a support for interconnecting said two lines (F11, F12) which are connected to said passages and situated to both sides of ground.

2. A balun as claimed in Claim 1, characterized in that each wire of the antenna is secured on the printed circuit at a distance (L) of approximately 50 mm from the other, the printed circuit having external dimensions of approximately 60 x 35 mm.
